# EUROPEAN PATENT APPLICATION

(11) **EP 4 535 420 A1**
(43) Date of publication of application: **09.04.2025**
(21) Application number: 23202133.7
(22) Date of filing: 06.10.2023
(51) Int. Cl.: H01L 23/48, H01L 23/00

(54) **A SEMICONDUCTOR COMPONENT COMPRISING STRUCTURED CONTACTS AND A METHOD FOR PRODUCING THE COMPONENT**

(71) Applicant: Imec VZW, 3001 Leuven (BE)
(72) Inventor: Derakhshandeh, Jaber, 3300 Tienen (BE); Beyne, Eric, 3001 Heverlee (BE)
(74) Representative: Patent Department IMEC

(57) **Abstract**

The component may be a semiconductor wafer (1) or die comprising a plurality of structured contacts (21,22) suitable for forming electrical connections to respective contacts of another semiconductor component, wherein each of said structured contacts comprises a planar contact surface (5',9') and a plurality of upright tube-shaped structures (20) extending outward from the planar contact surface. The tube-shaped structures (20) are preferably arranged in a regular array on the respective contact surfaces. According to the invention, such structures are produced by a sequence of steps including the patterning of a dielectric layer (8) formed on the front surface of the component, said patterning resulting in openings (10) in said dielectric layer, and the deposition of a conformal layer (11) on said patterned dielectric layer, thereby lining the bottom and sidewalls of the openings. The conformal layer is subsequently removed from the upper surface of the dielectric layer (8) and the material of said layer is removed selectively with respect to the conformal layer, resulting in said tube-shaped structures (20).

## Description

### Field of the Invention

The present invention is related to electrical bonding of semiconductor components such as chips or wafers. The invention is applicable to 3D stacking methods involving fine-pitched solder joints.

### State of the art.

The term '3D stacking' refers to techniques for producing a stack of two or more electrically interconnected semiconductor dies. Conventional thermalcompression bonding (TCB) for 3D interconnects often combines electroplated high melting point metal microbumps and/or contact pads, such as bumps or pads formed of Cu or Ni, with lower melting point solder metal like Sn. With a bonding temperature at or above the melting point of the solder, the liquid solder quickly reacts with the base metal to form an intermetallic compound joint. For Sn-based solder material, a bonding temperature higher than 250°C is needed. However, temperature sensitive devices, such as advanced memories and image sensors require low temperatures for 3D stacking to increase the capacity of memory and the resolution and quality of images.

Especially for die-to-wafer stacking, and because of the full cycle TCB applied for each die, the throughput that can be achieved by thermal compression bonding is becoming too low to meet the present industry's requirements. The high temperature cycles are also an obstacle for continued pitch scaling, i.e. the development of bump arrays toward smaller bump size and pitch. As the solder material melts, there is a growing risk for shorting neighbouring bumps as the pitch of the bump arrays becomes smaller. Finally, high temperature bonding can be detrimental to the alignment accuracy.

Low temperature solutions have been explored, and include the use of alternative solder materials such as indium-based solder, but these alternatives have not been able to match Sn-based solder in terms of the reliability of the bond. Another approach is the production of sharp structures on the contacts on one side of the bond to achieve a mechanical interlocking between the sharp structures and a solder material inserted therein, as described for example in patent publication document EP3754706. According to this method, the sharp structures are plate-shaped grains of an intermetallic compound formed prior to bonding. The dimensions and the distribution of the sharp structures are however not controllable, so that this method is not compatible with advanced pitch scaling developments.

### Summary of the invention

The invention is related to a semiconductor component and to methods for the production thereof, and to an assembly of components, as disclosed in the appended claims. The component may be a semiconductor wafer or die comprising a plurality of structured contacts suitable for forming electrical connections to respective contacts of another semiconductor component, wherein each of said structured contacts comprises a planar contact surface and a plurality of upright tube-shaped structures attached to said planar contact surface and extending outward from the planar contact surface. The tube-shaped structures are preferably arranged in a regular array on the contact surface. According to the invention, such structures are produced by a sequence of steps including the patterning of a dielectric layer formed on the front surface of the component, said patterning resulting in openings in said dielectric layer, and the deposition of a conformal layer on said patterned dielectric layer, thereby lining the bottom and sidewalls of the openings. The conformal layer is subsequently removed from the upper surface of the dielectric layer and the material of said layer is removed selectively with respect to the conformal layer, resulting in said tube-shaped structures.

The method and the component according to the invention enable the structuring of a planar contact surface by forming thereon said tube-shaped structures of sufficient sharpness and formed of a material of sufficient hardness so that the structures can be inserted in a solder bump or metal contact of a component configured to be bonded to the component comprising said structures. Said insertion thereby establishes a mechanical interlocking that improves the alignment of the bonded components, enables a higher throughput in the case of die-to-wafer bonding, and enables bonding the components at temperatures below the melting temperature of a solder bump when contacts according to the invention are used in a solder-based bonding process.

Advantageously, the number and dimensions of the tube-shaped structures can be controlled by the method of the invention, allowing to optimize these parameters as a function of the size of the contacts or of other parameters of components intended to be bonded.

The invention is in particular related to a semiconductor component having a front side and a back side and comprising on said front side a plurality of structured contacts suitable for forming electrical connections to respective contacts of another semiconductor component, characterized in that each of said structured contacts comprises a planar contact surface and a plurality of upright tube-shaped structures extending outward from the planar contact surface.

According to an embodiment, the tube-shaped structures have equal dimensions and are arranged in a regular pattern.

According to an embodiment, the planar contact surfaces of said contacts are lying inside respective cavities formed in a layer of dielectric material on the front side of the component and the top of the tube-shaped structures is inferior to the upper surface of said layer of dielectric material.

According to an embodiment, said tube-shaped structures are formed of a chemically inert material.

The invention is equally related to a method for producing a semiconductor component according to the invention, the method comprising the steps of :
- providing a semiconductor component comprising a plurality of contacts having a planar upper surface,
- producing a dielectric layer on the front surface of the component, said dielectric layer covering the contacts and having an upper surface parallel to the upper surface of the contacts,
- patterning the dielectric layer so as to form openings therein, positioned so that multiple openings are distributed across the planar upper surface of each contact, and wherein a portion of said upper surface of the contacts is exposed at the bottom of said openings,
- depositing a conformal layer on the patterned dielectric layer, so that the material of the conformal layer lines the bottom and sidewalls of said openings, as well as the upper surface of the dielectric layer,
- removing the material of the conformal layer from the upper surface of the dielectric layer,
- removing the material of the dielectric layer selectively with respect to the material of the conformal layer, so that multiple upstanding tube-shaped structures are formed on the upper surface of said contacts, thereby obtaining said structured contacts.

According to an embodiment of the method of the invention, the contacts are contact pads embedded in a layer of dielectric material that is coplanar with the planar upper surface of the contact pads, and the coplanar surfaces of the layer of dielectric material and of the contact pads form the front surface of the component.

According to an embodiment of the method of the invention, the contacts are contact bumps having a base portion embedded in a layer of dielectric material and a top portion extending outward from said layer of dielectric material.

According to an embodiment of the method of the invention, the step of removing the material of the conformal layer from the upper surface of the dielectric layer is performed by planarizing said upper surface of the dielectric layer.

According to an embodiment of the method of the invention, the material of the dielectric layer is removed by etching said material selectively with respect to the material of the conformal layer.

According to an embodiment of the method of the invention, an etch stop layer is produced on the component prior to producing the dielectric layer.

According to an embodiment of the method of the invention, the dielectric layer is a first dielectric layer, and the method further comprises the following steps performed after the step of removing the material of the conformal layer from the upper surface of the first dielectric layer :
- producing a second dielectric layer on the first dielectric layer,
- patterning the second dielectric layer so as to produce cavities therein, positioned above the respective planar surfaces of the contacts so that the openings, lined with the conformal layer, are exposed at the bottom of said cavities,
wherein the material of the first dielectric layer is removed only in said cavities.

According to an embodiment of the method of the invention, the method further comprises the step of filling the openings with a dummy material after the step of depositing the conformal layer, and the dummy material and the material of the conformal layer are removed from the upper surface of the dielectric layer by planarization, followed by the removal of the material of the dielectric layer and of the dummy material selectively with respect to the conformal layer.

The invention is equally related to a method for bonding a first semiconductor component according to the invention, comprising a plurality of first contacts, said first contacts being provided with said tube-shaped structures, to a second semiconductor component comprising a plurality of second contacts, the method comprising the consecutively applied steps of :
- producing solder bumps on the respective contacts of the second component,
- aligning the second component to the first component so that the solder bumps on the second contacts are aligned to the first contacts of the first component,
- at a temperature below the melting temperature of the solder bumps, bringing the first and second component together so that the tube-shaped structures of the first contacts are inserted in the solder bumps on the second contacts, thereby obtaining an assembly of the first and second component,
- annealing said assembly to thereby realize electrically conductive connections between the respective contacts of the first and second component.

According to an embodiment of the method according to the previous paragraph, the annealing step is performed at a temperature below the melting temperature of the solder bumps.

According to an embodiment of the method according to either one of the two previous paragraphs, the method further comprises the step of applying an underfill material on the second component prior to bonding, and of planarizing the underfill material and the solder bumps on the second component to a common planarized surface.

The invention is equally related to a method for bonding a first semiconductor component according to the invention, comprising a plurality of first contacts, said first contacts being provided with said tube-shaped structures, to a second semiconductor component comprising a plurality of second contacts, the method comprising the consecutively applied steps of :
- aligning the second component to the first component so that the second contacts are aligned to the first contacts,
- bringing the first and second component together so that the tube-shaped structures of the first contacts are inserted into the second contacts, thereby obtaining an assembly of the first and second component,
- annealing said assembly to thereby realize electrically conductive connections between the respective contacts of the first and second component through solid-state interdiffusion.

The invention is equally related to an assembly of stacked and electrically connected semiconductor components, comprising at least two components connected by connections formed between respective contacts of said two components, wherein multiple tube-shaped structures are embedded in each one of a plurality of said connections.

### Brief description of the figures

Figure 1 illustrates a small section of an integrated circuit (IC) processed on a silicon wafer, illustrating the constituent layers of the IC and a number of contact pads.
Figures 2 to 10 illustrate key steps of a method according to an embodiment of the invention, for producing sharp structures on a contact pad of the IC illustrated in Figure 1.
Figures 11 to 12 illustrate an alternative method for producing said sharp structures on the contact pad.
Figures 13 to 15 illustrates a further alternative method for producing said sharp structures.
Figures 16 to 19 illustrate a structured contact bump in accordance with an embodiment of the invention.
Figures 20a to 20d illustrate bonding processes wherein a solder bump is bonded to a contact pad structured in accordance with an embodiment of the invention.
Figures 21a to 21c illustrate a bonding process wherein a direct metal-to-metal bond is realized between a structured metal contact pad according to the invention and a contact bump.
Figures 22a to 22c illustrate a direct hybrid bonding process using structured contact pads in accordance with the invention.
Figure 123 illustrates a bonding process for bonding multiple stacked dies, using bonding pads structured in accordance with the invention.

### Detailed description of the invention

The invention will be described on the basis of an exemplary embodiment, which is however not limiting the scope of the invention. All references with respect to shapes, dimensions or materials are cited by way of example only and alternatives for these parameters will be described at various instances throughout the description.

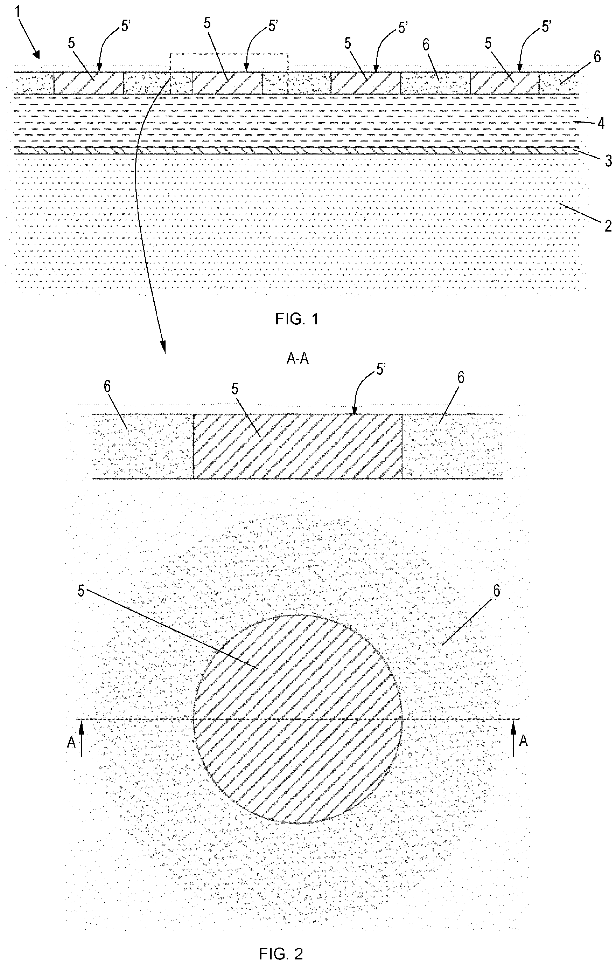

Figure 1 is a schematic representation of a silicon process wafer 1 onto whose front surface a plurality of integrated circuit chips have been processed. The image shows a cross-section of a small portion of one chip, including a bulk Si part 2, a front end of line (FEOL) part 3 comprising active devices such as transistors or diodes, and a back end of line (BEOL) part 4 which is a multilevel structure of interconnected electrical conductors and vias designed to provide signal routing to the active devices, and embedded in an electrically isolating dielectric material. The chip further comprises a regular array of copper contact pads 5 connected to the top level of the BEOL part 4. In the plane of the wafer 1, the pads 5 have a circular cross-section with a diameter of about 2 µm. The thickness of the pads 5 is less than 1 µm. The pitch of the array of contact pads 5 is about twice the diameter of the pads 5. As stated, these shapes and dimensions do not limit the scope of the invention, but are used as examples only. The invention is applicable to contact pads of any shape or dimension that is practically applicable on a semiconductor component, ranging for example from about 1 µm to 10 µm in terms of its main characterizing in-plane dimension (the diameter for circular contact pads, for example the diagonal for square or rectangular contact pads). Besides copper, other metals can be used as the material of the contact pads, for example aluminium or nickel. Metals applicable for use in such contact pads are known as such in the art.

The pads 5 are laterally embedded in a layer 6 of dielectric material which isolates the pads electrically from each other, i.e. the layer 6 surrounds the pads 5, leaving the upper surface 5' of the contact pads free and coplanar with the isolating layer 6. The electrically isolating layer 6 may be a single layer or a stack of separate layers of different dielectric materials. The pads 5 may be processed by the well-known damascene-type processing technique used for producing BEOL type interconnect structures. Usually, a diffusion barrier (not shown in Figure 1) is present between the contact pads 5 and the dielectric isolation layer 6.

A 'contact' of a semiconductor component is defined within the present context as either a contact pad or a contact bump. A contact pad 5 is as described above, i.e. it is fully embedded in a dielectric layer 6 and has an upper planar surface 5' that is coplanar with the upper surface of the dielectric layer 6. A contact bump has a base portion that is fully embedded in a dielectric layer and a top portion that protrudes outward from the dielectric layer. The invention is applicable also to such contact bumps, having a planar upper surface (i.e. the planar upper surface of the top portion). A structured contact is defined in the present context as a contact having a planar upper surface with structures extending outward from said surface. The method for producing such a structured contact according to the invention will first be described in some detail for the case of a contact pad.

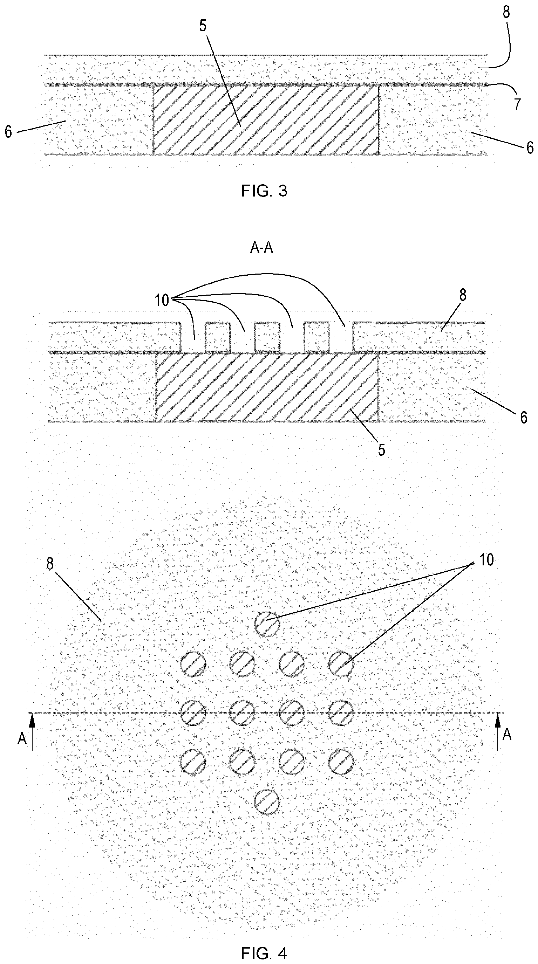

Figure 2 shows a section view and a plane view of one single contact pad 5, as the starting point for a number of method steps performed on the wafer 1 in accordance with an embodiment of the invention. With reference to Figure 3, two layers 7 and 8 are produced on the coplanar upper surface of the contact pad 5 and the isolating layer 6. These layers 7 and 8 are formed across the full surface of the wafer 1. The first layer 7 is a thin etch stop layer, for example a SiN or SiCN layer. The layer is referred to as an etch stop layer with respect to one or more etch processes applied at a later stage of the method, as will be described further. The etch stop layer 7 is thin, for example in the order of less than 10 nm.

The second layer 8 is a dielectric layer, for example a silicon oxide layer having a thickness of about 300 nm. Any known technique for producing these layers 7 and 8 is applicable. The skilled person is familiar with such techniques, therefore details thereof are not included in the present description.

With reference to Figure 4, the stack of the etch stop layer 7 and the dielectric layer 8 is patterned in an area above the contact pad 5. The same patterning is preferably applied above all the contact pads 5 of the chip. The pattern comprises a plurality of circular openings 10 of small diameters relative to the diameter of the contact pad 5. The openings are distributed across the surface area of the contact pad 5 and are preferably arranged in a regular pattern as shown in the top view in Figure 4.

The diameter of the openings may for example be about 200 nm. Producing the openings 10 can be done by lithography and etching techniques known as such in the art. One applicable method for producing openings of these dimensions is to a produce a hardmask stack on the dielectric layer 8, formed of a stack of a Dielectric Anti Reflective Coating (DARC), a Bottom layer Anti Reflective Coating (BARC) and a photoresist layer, patterning the resist layer and etching to form openings in the DARC/BARC layer stack and transferring these openings to the underlying dielectric layer 8 by an anisotropic etch process, followed by stripping the hardmask.

The etch stop layer 7 serves to stop the anisotropic etch process if said process is not selective with respect to the Cu of the contact pad 5. Etch stop layer 7 also serves to stop wet etching steps described further in this text. The etch stop layer 7 is then removed in the openings 10 by a selective etch recipe to thereby expose the upper surface of the contact pad 5 at the bottom of the openings 10, as illustrated in Figure 4.

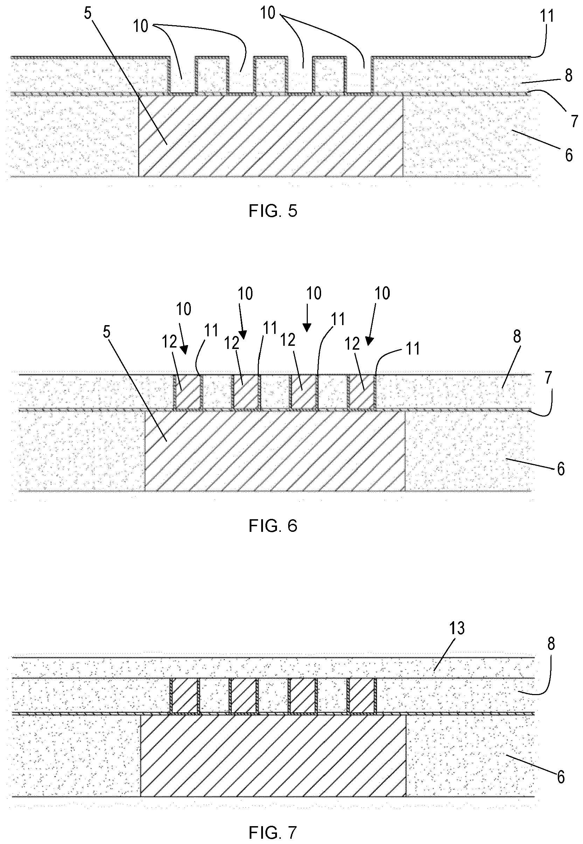

With reference to Figure 5, a thin layer 11 is produced conformally on the dielectric layer 8, i.e. layer 11 follows the topography defined by the layer 8 and the openings 10 formed therein. The layer 11 is a tantalum layer in the represented embodiment, although other materials are possible as will be explained further. The thickness of layer 11 may be about 10 nm. As seen in the image, the Ta layer 11 lines the bottom and sidewalls of the openings 10.

After this and with reference to Figure 6, the Ta-lined openings 10 are filled with a sacrificial material 12 (i.e. a material that will later again be removed). This may be Cu or any other suitable dummy material. Cu may be deposited in the openings 10 by electroplating, which will also form a layer of Cu on top of the dielectric layer 8. A planarization step is then performed, for example including grinding and CMP (chemical mechanical polishing), removing both the electroplated Cu and the Ta from the upper surface of the dielectric layer 8. The result of the planarization is shown in Figure 6.

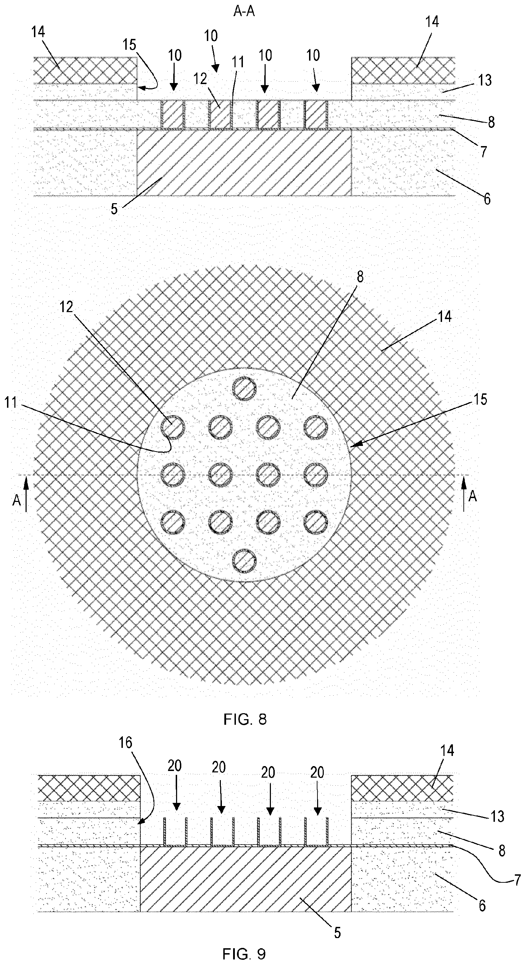

A second dielectric layer 13 is then produced on the planarized surface, see Figure 7. This layer 13 is thinner than layer 8 in the represented embodiment, but this is not a requirement of the invention. With reference to Figure 8, a resist layer 14 is produced on the second dielectric layer 13 and by standard lithography and etching, the resist layer 14 and the second dielectric layer 13 are patterned to form a cavity 15 therein. The same type of cavity is preferably formed on the other contacts pads 5 of the chip. As shown, the cavity 15 may have a circular cross-section of the same diameter as the contact pad 5 and be aligned to said contact pad 5. A small difference in diameter and/or a small misalignment for example due to an overlay error in the lithography step is however allowed. When the cavity 15 is formed, the Ta-lined and Cu-filled openings 10 are exposed at the bottom of said cavity 15, as shown in Figure 8.

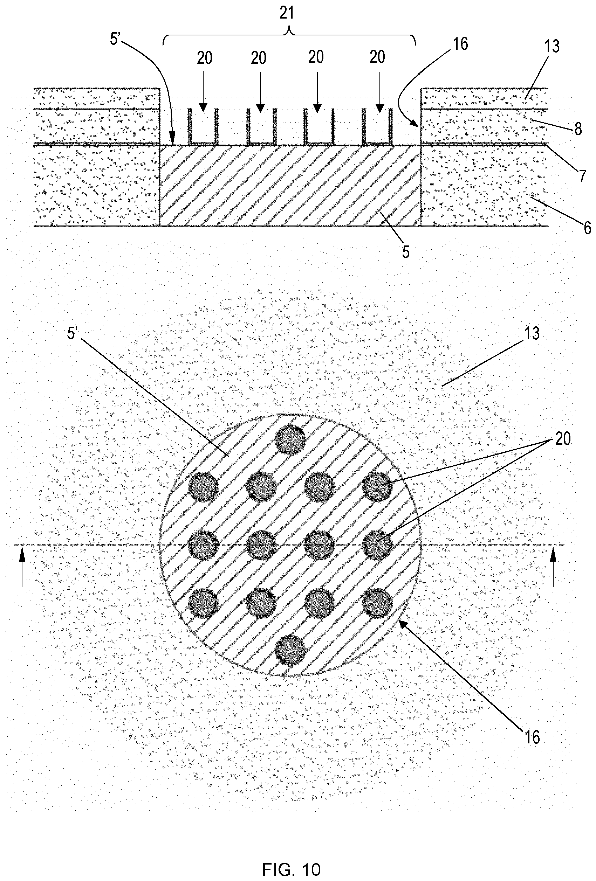

In the next step illustrated in Figure 9, and with the resist 14 still in place, the dielectric material of dielectric layer 8 and the sacrificial material 12 are removed starting from the bottom of the cavity 15. The removal of these materials may be done by one or more suitable wet etch recipes which enable said removal selectively with respect to the Ta linings 11 of the openings 10 and with respect to the etch stop layer 7, i.e. etch stop layer 7 stops the etch process applied for removing the material of dielectric layer 8 and of sacrificial material 12. Then the etch stop layer 7 is also removed selectively which may be done by a dry etch process, with respect to the linings 11, and with respect to the material of the contact pad 5. Thereafter, the resist 14 is stripped, resulting in the section and top views as represented in Figure 10.

The Ta linings are now referenced with a new reference number 20, indicating upright tube-shaped structures extending outward from the planar surface 5' of the contact pad 5, at the bottom of a cavity 16 formed in the stack of dielectric layers 8 and 13. In the embodiment shown, the etch selectivity of the etch recipes referred to above is considered to be 100%. As a consequence, the original Ta linings on the bottom and sidewalls of the openings 10 are fully preserved. In reality, the etch selectivity is less than 100% and said linings may be affected by the etch process to some degree. For example, the Ta formed on the bottom of the openings could be partially or fully removed and the linings on the sidewalls could be slightly shortened. The etch selectivity is however sufficient to enable the production of tube-shaped structures of significant height extending upward from the contact pad 5. In the embodiment shown, this height is in the order of 300 nm. However, this height may be much higher according to other embodiments, which may include tube-shaped structures of 1 µm in height and more. Such structures may be produced on contact pads of larger diameters than the ones illustrated, for example on circular contact pads of 10 µm in diameter. The planar contact pad 5 including the tube-shaped structures 20 may be referred to as a structured contact pad 21 in accordance with an embodiment of the invention. In the wording of the appended claims, the wafer 1 has been provided with a contact 21 comprising a planar contact surface 5', provided with a plurality of upright tube-shaped structures 20 extending outward from the planar contact surface 5'.

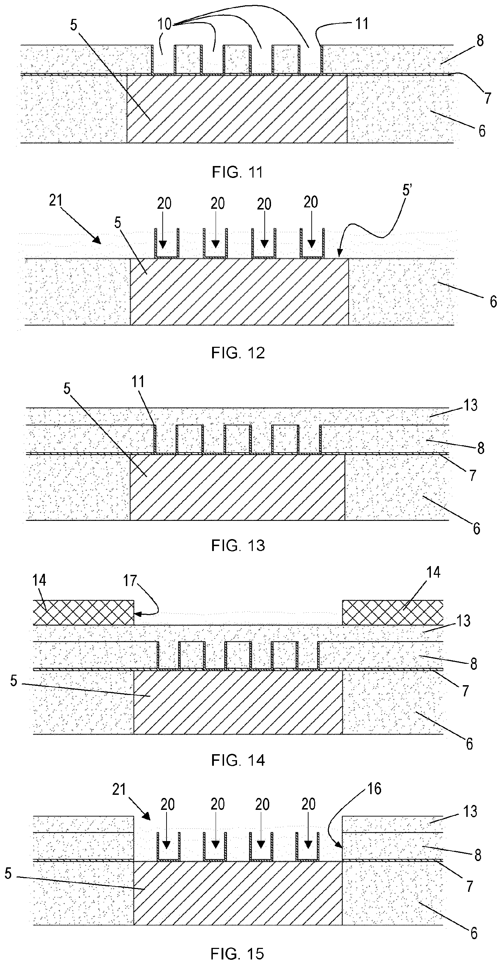

An alternative method of producing a contact pad provided with tube-shaped structures 20 is illustrated with reference to Figures 11 and 12. According to this method, no dummy material is used, and a CMP step is applied directly after the formation of the conformal layer 11, i.e. after the step illustrated in Figure 5. This CMP step removes the layer 11 from the upper surface of the dielectric layer 8 while maintaining it on the bottom and sidewalls of the openings 10. Following this, the material of the dielectric layer 8 is removed by etching relative to the layer 11, stopping on the etch-stop layer 7. The latter etch-stop layer 7 is then removed by a suitable etch recipe, resulting in the image shown in Figure 12. The structures 20 now extend outward from the coplanar surface of the contact pads 5 and the dielectric isolation layer 6. The structured contact pads 21 obtained in this way are suitable for bonding the wafer 1 to another component in a direct hybrid bonding process, as will be described further.

It is also possible to avoid using the dummy material and nevertheless arrive at the tube-shaped structures 20 being located in a cavity 16, as illustrated in Figures 13 to 15. After the CMP step wherein the layer 11 is removed from the upper surface of the dielectric layer 8 (as in Figure 11), a second dielectric layer 13 is deposited, filling the openings 10 and forming the layer 13 on top of the first dielectric layer 8 (as shown in Figure 13). Said layer 13 may be planarized by CMP to form a planar upper surface as shown. Then a photoresist 14 is produced and patterned so as to form a cavity 17 therein (see Figure 14), and this cavity 17 is transferred by etching into the stack of layers 8 and 13 (see Figure 15), to form the cavities 16 after stripping the resist 14.

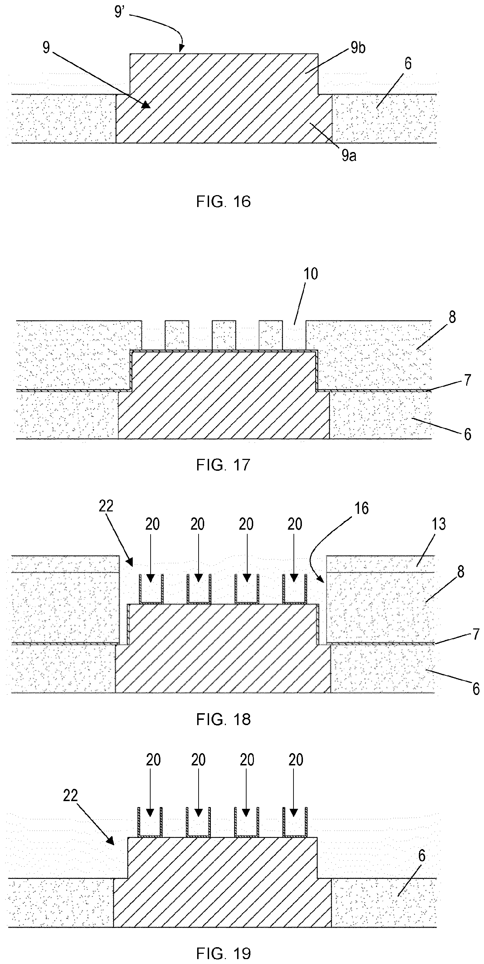

Figure 16 shows an example of a contact in the form of a metal bump 9, comprising a base portion 9a embedded in a layer 6 of dielectric material, and a top portion 9b protruding outward from the dielectric layer 6, the top portion 9b having a planar upper surface 9'. The invention is applicable also to such contacts. The method for producing a structured contact bump according to the invention comprises largely the same steps as described for the case of a contact pad. As shown in Figure 17, etch stop layer 7 and dielectric layer 8 are deposited, layer 8 is planarized so that its upper surface is parallel to the planar upper surface of the contact bump 9, and openings 10 are produced. Following this, the method of the invention can be applied according to the various embodiments described above. This may lead to the result shown in Figure 18, i.e. a structured contact bump 22 comprising the tube-shaped structures 20 lying inside a cavity 16 formed in the stack of dielectric layers 8 and 13, or to the result shown in Figure 19, i.e. a structured contact bump 22 protruding outward from the dielectric layer 6.

An advantage of applying the tube-shaped structures 20 to a contact bump 9 is that in the case of a solder-based bond, molten or softened solder material is able to form around the sidewalls of the bump.

The function of the tube-shaped structures 20 is to interlock with contact material that is part of or attached to another component in a bonding process wherein said other component is bonded to a component comprising structured contact pads or bumps in accordance with the invention. The contact material may be a solder bump attached to the other component or a metal contact pad or bump of the other component. To this aim, the material of the structures 20 must have a hardness higher than said contact material. It is preferred also that the material of the structures 20 is chemically inert so that it does not interfere with the formation of intermetallic compounds during the bonding process. For example the following materials : Ta, TaN, Pt or Au are inert materials of sufficient hardness suitable for interlocking with a solder material in a solder-based bonding process or with a contact bump or pad in a direct metal-to-metal bonding process. The wall thickness of the structures 20 is such that the structures have a sufficient degree of sharpness so that they can be inserted into a contact material of another component in a bonding process.

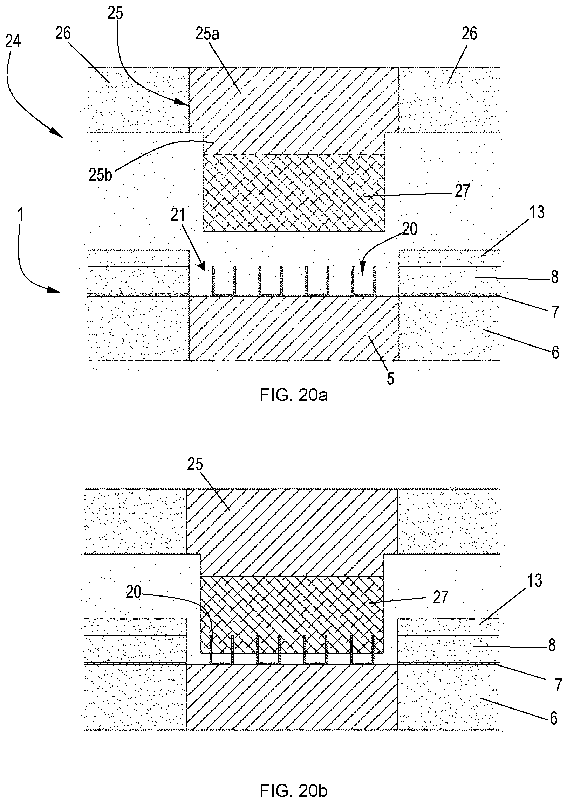

Examples of solder-based bonding processes are illustrated in Figures 20a to 20c. Figure 20a shows the structured contact pad 21 on the wafer 1, i.e. comprising a planar contact pad 5 provided with the tube-shaped structures 20. The tube-shaped structures 20 are oriented upwards, as is the case when the Si wafer 1 is positioned on a horizontal holding table in a solder bonding tool known as such in the art. The wafer 1 is the first component in the bonding process, wherein a second component is to be bonded and electrically connected to the first component. As seen in Figure 20a, the second component 24 comprises a Cu contact bump 25. The contact bump 25 has a base portion 25a embedded in a dielectric isolating layer 26 and a protruding top portion 25b. The second component 24 may be another process wafer comprising multiple integrated circuit dies, to be bonded to the wafer 1 in a wafer-to-wafer bonding process, or it may be single die to be bonded to the wafer 1 in a die-to-wafer bonding process. The contact bump 25 of the second component has received thereon a solder bump 27 which may be applied by a known technique, such as by electroplating. The protruding top portion 25b of the bump 25 has a circular cross-section having a diameter that is smaller than the diameter of the contact pad 5 on the wafer 1 and the diameter of the solder bump 27 is about the same as the diameter of the protruding portion 25b. The solder material may be any solder material known in the art, for example Sn. The thickness of the solder bump 27 is in the order of 1 to 1.5 µm.

The bonding sequence may be in accordance with known solder-based bonding sequences, including bonding sequences wherein the temperature is not raised above the melting temperature of the solder material. Examples of such a sequence will be briefly described hereafter for the case of a die-to-wafer bonding process. As seen in Figure 20b, the second component 24 (i.e. a single die) is lowered until the tube-shaped structures 20 are inserted in the solder material of the bump 27. This may be done at room temperature but the temperature is preferably higher than room temperature but still below the solder's melting point, so that the solder is softened to some degree. By the insertion of the tube-shaped structures 20 into the solder, a mechanical interlocking is achieved between the contact pad 5 and the solder bump 27. This stage of the process is done in a pick-and-place tool, wherein multiple dies are placed sequentially onto the wafer 1.

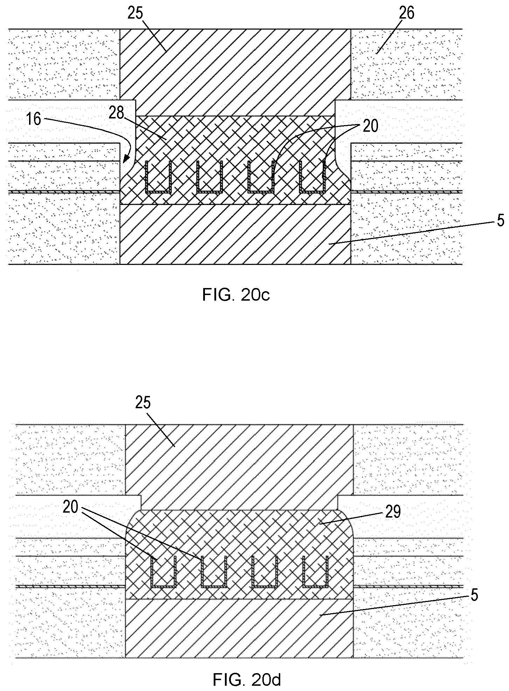

This is followed by an anneal step in a batch annealing tool, wherein the assembly of the wafer 1 with multiple dies 24 attached thereto is heated during a given time and at a given temperature, and possibly while applying a downward pressure on the dies 24. The anneal temperature may be a temperature below the melting point of the solder material, at which temperature intermetallic compounds are formed through solid-state interdiffusion between the material of the contacts 5 and 25 on the one hand and the solder material on the other hand. Such low temperature annealing may result in a solder-based connection 28 illustrated in Figure 20c. It is seen that the solder has softened at the raised temperature so that it partially fills the cavity 16. The connection 28 is formed of solder material and of intermetallic compounds resulting from the interdiffusion of elements from the solder bump 27 and from the contacts 5 and 25.

The anneal step can also be performed at a temperature above the solder's melting point, which results in a solder connection 29 illustrated in Figure 20d. The original solder bump has fully melted and reflowed, resulting in the connection 29 filling up the entire cavity 16.

Figures 20c and 20d represent the preferred case wherein the tube-shaped structures 20 are chemically inert, so that these structures 20 remain in the final solder connection 28 or 29.

The bonding sequence for a wafer-to-wafer bonding process (second component 24 is a wafer) is analogous to the above. The insertion of the tube-shaped structures 20 into the solder bumps 27 then takes place simultaneously for all the dies on the second component.

The mechanical interlocking of the structures 20 into the solder bumps 27 enables realizing a high throughput in the case of die-to-wafer bonding because the alignment between interlocked contacts is maintained between the pick-and-place tool and the annealing tool. Also, solid-state interdiffusion is facilitated as a consequence of the plastic deformation following from the insertion of the sharp structures 20 into the solder bump 27. Although bonding above the solder's melting point remains possible, this functionality enables bonding processes to be performed at temperatures which are certain not to damage devices on the bonded components. These functionalities are similar to the function of the sharp plate-shaped grains of the interlocking layer disclosed in EP3754706. The difference is that the position and dimensions of the tube-shaped structures 20 can be controlled so that the interlocking function can be optimized as a function of the contact pad dimensions and the applied materials. This makes it possible to produce suitably dimensioned tube-shaped structures 20 on contacts of small dimensions and pitch so that melting of solder bumps can be avoided for these small dimensions, thereby avoiding shorting between neighbouring solder connections. In other words, advanced pitch scaling is enabled by this invention.

Another advantage of the invention is that the sharp structures are able to penetrate oxides formed on the surface of the solder material. In standard solder bonding, fluxing is applied prior to bonding, in order to remove these oxides. The flux material however leaves residuals on the bumps which can raise reliability issues. Due to the mechanical breakup of the oxide layers, fluxing is not needed when applying structured contacts, i.e. comprising the tube-shaped structures 20, in accordance with the invention.

From the foregoing descriptions it is clear that the tube-shaped structures 20 produced on the contact 5 or 9 must be harder than the solder material at the temperature applied during the insertion of the structures into the solder, so that the structures 20 are not deformed by said insertion process. This represents a requirement for the material and thickness of the structures in question. As stated, Ta or Ti or Pt or TaN or TiN or Au are suitable materials when used in combination with most known solder materials.

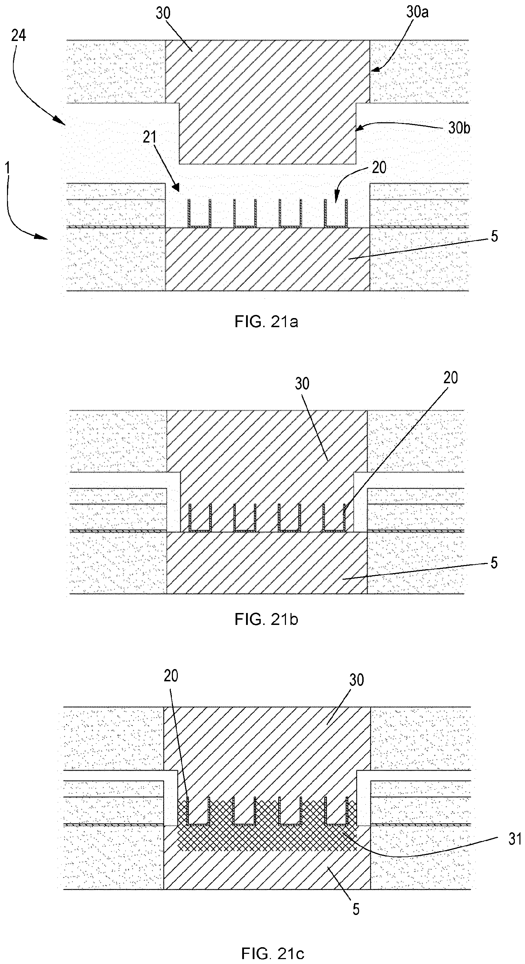

The invention is however not limited to solder-based bonding, but may also be applied in a direct bonding process, wherein contacts are bonded together by solid-state interdiffusion without the intervention of a solder material. This is first illustrated by the bonding sequence shown in Figures 21a to 21c. The contact on the second component 24 is now a Cu contact bump 30 comprising a base portion 30 and a protruding top portion 30b. When lowered towards the contact pad 5 on the first component, provided with the tube-shaped structures 20, these structures are inserted into the Cu contact bump 30, provided that the hardness of the structures exceeds that of the Cu bump significantly. This may be done at room temperature or in any case at a temperature far below the melting temperature of Cu. The insertion of the structures into the Cu takes place by local plastic deformation of the upper Cu pad 30, thereby establishing a mechanical interlocking as in the case of the solder bump. To enable or facilitate said insertion and plastic deformation, it may be advantageous to produce the upper bump in Cu having a higher porosity than is normally the case .

Annealing is then applied, preferably while the second component 24 is pressed down on the first component, so that a solid state interdiffusion of the Cu contacts is realized. In the die-to-wafer bonding case, this may be done in a batch annealing tool, following the sequential pick-and-place of a plurality of dies. The result is shown in Figure 21c. An interdiffusion zone 31 is formed wherein Cu-Cu interdiffusion has taken place, forming a strong conductive bond. Said interdiffusion is normally happening at temperatures in the range of 250-350°C when two planar Cu surfaces are pressed together. However, this temperature may be reduced when applying the tube-shaped structures 20 on one side. This is because the local plastic deformation caused by the insertion of the structures 20 into the Cu bump 30 creates areas at which the interdiffusion may be facilitated so that it starts at a lower temperature compared to the planar case.

In the bonding sequences illustrated in Figures 20a-20d and 21a-21c, no underfill material is shown. However in most cases it is preferred to fill the space between the components with such an underfill material, that seals the connections off from the exterior of the bonded assembly.

Applying an underfill material in the case of a bonding process comprising contacts structured according to the invention may be done in any way known in the art today. The underfill may be any material known for this purpose. Best known materials therefore are thermoplastic polymers which enter the spaces between the bonded contacts in a fluid state under a raised temperature and thereafter harden into a resin-like matrix. Underfill may be applied post-bonding or pre-bonding. In the latter case, the underfill material is preferably applied to the component that does not have the tube-shaped structures on the contacts. As known in the art, applying underfill material pre-bonding is advantageous as it can be instrumental in reducing the bump height non-uniformity of solder bumps across a wafer. This is done by applying the underfill in liquid state after applying the solder bumps, followed by cooling the wafer so that the underfill material hardens. The wafer is then subjected to CMP to planarize the underfill material and the bumps to a common coplanar surface, thereby removing any bump height non-uniformity. Given the fact that contacts structured according to the invention are preferably applied in low temperature bonding sequences, it is preferred to apply the above-described pre-bond underfill and planarization step. Otherwise, the bump height non-uniformity can be such that the only way to bond the wafers is by heating above the melting temperature of the solder bumps.

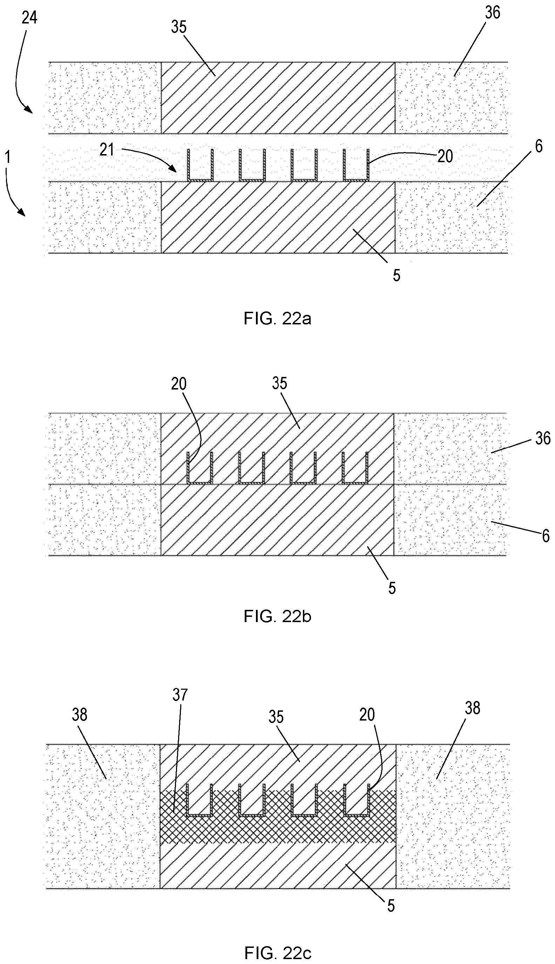

Figures 22a-22c illustrate a direct hybrid bonding process using structured contacts pads 21 in accordance with the invention on one of the bonded components. The contact pads 21 obtained by the method illustrated in Figures 11 and 12 are suitable for this purpose. According to this approach a flat top wafer or die 24 comprising Cu pads 35 coplanar with a dielectric layer 36 is bonded to a flat bottom wafer 1 having structured Cu pads 21 coplanar with dielectric layer 6, as illustrated in Figure 22a. The dielectric material on the surface of both wafers is suitable in a direct dielectric-to-dielectric bonding process. This material may for example be SiCN or SiO2. The Cu pads will be bonded by a direct Cu-Cu bond, as in the bond between the pad 5 and the Cu bump 30 in the previous embodiment. The term hybrid bonding refers to the fact that a metal-metal bond and a dielectric-dielectric bond are realized simultaneously. No underfill material is required in this case.

As seen in Figure 22b, the top component 24 is pressed onto the bottom component 1, until the structures 20 are inserted into the contact pad 35 of the top component. With reference to Figure 22c, a bonding anneal under a given pressure then realizes the conductive bond through Cu-Cu interdiffusion in area 37 between the pads 5 and 35 and the dielectric-dielectric bond between the layers 6 and 36. If both layers 6 and 36 are uniformly formed of the same material, e.g. SiO₂, a uniform dielectric layer 38 is the result of the dielectric-dielectric bonding. As in the previous case, Cu-Cu interdiffusion may take place at lower temperatures compared to bonding between planar contacts.

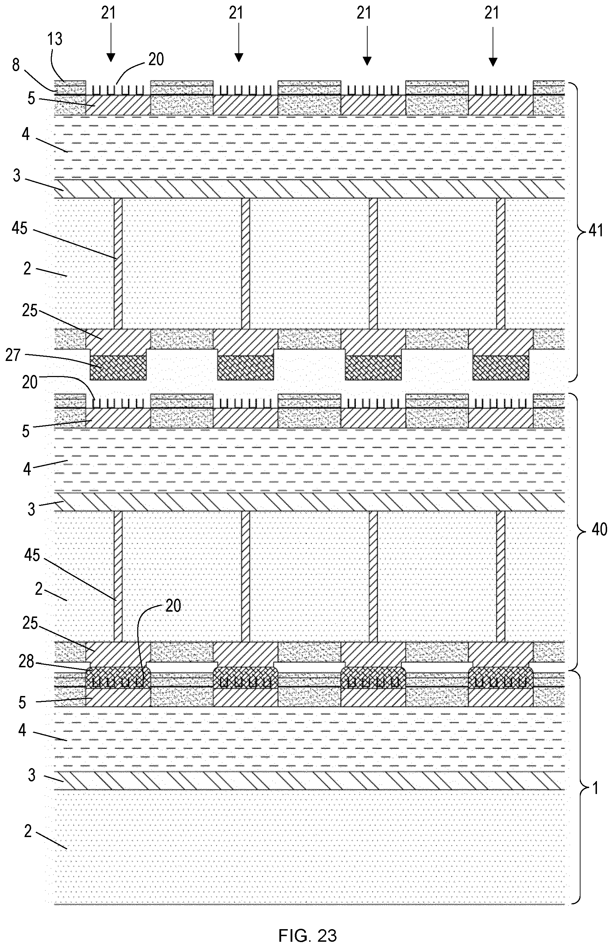

Figure 23 illustrates the use of structured bonding pads in accordance with the invention in a bonding sequence for producing multiple stacked dies 40,41 on the wafer 1. Constituent parts of the wafer and of the dies 40,41 have been numbered by the same numerical references used in the above descriptions, e.g. substrate portion 2, FEOL and BEOL portions 3,4, contact pads 5 and contact bumps 25 etc. Both dies 40,41 comprise structured contact pads 21 according to the invention on their front side, i.e. planar contact pads 5 provided with upright tube-shaped structures 20 on their upper surface, and TSV (Through substrate via) connections 45 from their FEOL portion 3 to the back side of the dies, which are provided with back side contact bumps 25 as described above, with solder bumps 27 plated thereon. A stacked assembly of dies according to the invention is characterized by the presence of the tube-shaped structures 20 embedded in the connections which interconnect the dies. These connections may be the solder/intermetallic bumps 28,29 in Figures 20c and 20d or the intermetallic diffusion areas 31,37 in Figures 21c and 22c (in the latter case, the structures 20 may be only partially embedded in these areas 31,37).

The presence of the dielectric layers 8 and 13 represents an advantage for the bonding process. As a consequence of the method for producing the structured contacts 21,22 according to the invention, the top of the tube-shaped structures 20 is inferior to the upper surface of the stack of layers 8+13. These layers therefore enable attaching the dies 40,41 to a holding chuck without directly contacting the tube-shaped structures 20, thereby avoiding damage to said structures during handling of the dies.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A semiconductor component (1) having a front side and a back side and comprising on said front side a plurality of structured contacts (21,22) suitable for forming electrical connections to respective contacts of another semiconductor component, **characterized in that** each of said structured contacts comprises a planar contact surface (5',9') and a plurality of upright tube-shaped structures (20) extending outward from the planar contact surface.

2. The semiconductor component according to claim 1, wherein the tube-shaped structures (20) have equal dimensions and are arranged in a regular pattern.

3. The semiconductor component according to claim 1 or 2, wherein the planar contact surfaces (5',9') of said contacts (21,22) are lying inside respective cavities (16) formed in a layer (8,13) of dielectric material on the front side of the component (1) and wherein the top of the tube-shaped structures (20) is inferior to the upper surface of said layer of dielectric material (8,13).

4. The semiconductor component according to any one of claims 1 to 3, wherein said tube-shaped structures (20) are formed of a chemically inert material.

5. A method for producing a semiconductor component (1) according to any one of claims 1 to 4, the method comprising the steps of :
- providing a semiconductor component (1) comprising a plurality of contacts (5,9) having a planar upper surface (5',9'),
- producing a dielectric layer (8) on the front surface of the component, said dielectric layer covering the contacts (5,9) and having an upper surface parallel to the upper surface (5',9') of the contacts,
- patterning the dielectric layer (8) so as to form openings (10) therein, positioned so that multiple openings are distributed across the planar upper surface (5',9') of each contact, and wherein a portion of said upper surface (5',9') of the contacts is exposed at the bottom of said openings (10),
- depositing a conformal layer (11) on the patterned dielectric layer (8), so that the material of the conformal layer lines the bottom and sidewalls of said openings (10), as well as the upper surface of the dielectric layer (8),
- removing the material of the conformal layer (11) from the upper surface of the dielectric layer (8),
- removing the material of the dielectric layer (8) selectively with respect to the material of the conformal layer (11), so that multiple upstanding tube-shaped structures (20) are formed on the upper surface (5',9') of said contacts (5,9), thereby obtaining said structured contacts (21,22).

6. The method according to claim 5, wherein the contacts are contact pads (5) embedded in a layer (6) of dielectric material that is coplanar with the planar upper surface (5') of the contact pads, and wherein the coplanar surfaces of the layer (6) of dielectric material and of the contact pads (5) form the front surface of the component (1).

7. The method according to claim 5, wherein the contacts are contact bumps (9) having a base portion (9a) embedded in a layer (6) of dielectric material and a top portion (9b) extending outward from said layer of dielectric material.

8. The method according to any one of claims 5 to 7, wherein an etch stop layer (7) is produced on the component (1) prior to producing the dielectric layer (8).

9. The method according to any one of claims 5 to 8, wherein the dielectric layer (8) is a first dielectric layer, and further comprising the following steps performed after the step of removing the material of the conformal layer (11) from the upper surface of the first dielectric layer (8) :
- producing a second dielectric layer (13) on the first dielectric layer (8),
- patterning the second dielectric layer (13) so as to produce cavities (15) therein, positioned above the respective planar surfaces (5',9') of the contacts (5,9) so that the openings (10), lined with the conformal layer (11), are exposed at the bottom of said cavities (15),
and wherein the material of the first dielectric layer (8) is removed only in said cavities (15).

10. The method according to any one of claims 5 to 9, further comprising the step of filling the openings (10) with a dummy material (12) after the step of depositing the conformal layer (11), and wherein the dummy material (12) and the material of the conformal layer (11) are removed from the upper surface of the dielectric layer (8) by planarization, followed by the removal of the material of the dielectric layer (8) and of the dummy material (12) selectively with respect to the conformal layer (11).

11. A method for bonding a first semiconductor component (1) according to any one of claims 1 to 4, comprising a plurality of first contacts (21,22), said first contacts being provided with said tube-shaped structures (20), to a second semiconductor component (24) comprising a plurality of second contacts (25),
the method comprising the consecutively applied steps of:
- producing solder bumps (27) on the respective contacts (25) of the second component (24),
- aligning the second component (24) to the first component (1) so that the solder bumps (27) on the second contacts (25) are aligned to the first contacts (21,22) of the first component (1),
- at a temperature below the melting temperature of the solder bumps (27), bringing the first and second component (1,24) together so that the tube-shaped structures (20) of the first contacts (21,22) are inserted in the solder bumps (27) on the second contacts (25), thereby obtaining an assembly of the first and second component,
- annealing said assembly to thereby realize electrically conductive connections (28,29) between the respective contacts (21,22;25) of the first and second component (1,24).

12. The method according to claim 11, wherein the annealing step is performed at a temperature below the melting temperature of the solder bumps (27).

13. The method according to any one of claims 11 or 12, further comprising the step of applying an underfill material on the second component (24) prior to bonding, and of planarizing the underfill material and the solder bumps (27) on the second component to a common planarized surface.

14. A method for bonding a first semiconductor component (1) according to any one of claims 1 to 4, comprising a plurality of first contacts (21,22), said first contacts being provided with said tube-shaped structures (20), to a second semiconductor component (24) comprising a plurality of second contacts (30,35),
the method comprising the consecutively applied steps of:
- aligning the second component (24) to the first component (1) so that the second contacts (30,35) are aligned to the first contacts (21,22),
- bringing the first and second component (1,24) together so that the tube-shaped structures (20) of the first contacts (21,22) are inserted into the second contacts (30,35), thereby obtaining an assembly of the first and second component,
- annealing said assembly to thereby realize electrically conductive connections (31,37) between the respective contacts (21,22;25,35) of the first and second component (1,24) through solid-state interdiffusion.

15. An assembly of stacked and electrically connected semiconductor components (1,40,41), comprising at least two components connected by connections (28,29,31,37) formed between respective contacts of said two components, wherein multiple tube-shaped structures (20) are embedded in each one of a plurality of said connections.
